# EUROPEAN PATENT APPLICATION

(11) **EP 4 610 727 A2**
(43) Date of publication of application: **03.09.2025**
(21) Application number: 25159601.1
(22) Date of filing: 24.02.2025
(51) Int. Cl.: G03F 7/00

(54) **HOLDING APPARATUS, SUBSTRATE PROCESSING APPARATUS AND ARTICLE MANUFACTURING METHOD**

(30) Priority: 29.02.2024 JP 2024030641
(71) Applicant: CANON KABUSHIKI KAISHA, Tokyo 146-8501 (JP)
(72) Inventor: CHOMEI, Takuma, Tokyo, 146-8501 (JP); KOYA, Shigeo, Tokyo, 146-8501 (JP); NAKAJIMA, Kazunori, Tokyo, 146-8501 (JP); MORIKUNI, Yuichiro, Tokyo, 146-8501 (JP); WATANABE, Hikari, Tokyo, 146-8501 (JP)
(74) Representative: TBK

(57) **Abstract**

A holding apparatus that holds a substrate, including a chuck configured to hold the substrate, a supply mechanism configured to supply a gas to a first space between the substrate and the chuck via first holes provided at first positions of the chuck, an opening mechanism configured to make the first space and an outer space communicate with each other via second holes provided at second positions of the chuck that are different from the first positions, and a controller configured to control the supply mechanism and the opening mechanism so that a period during which holding of the substrate by the chuck is stopped includes a period during which supplying of the gas to the first space and communicating between the first space and the outer space are performed simultaneously.

## Description

### BACKGROUND

### Technical Field

The present disclosure relates to a holding apparatus, a substrate processing apparatus and an article manufacturing method.

### Description of the Related Art

A substrate chuck is used to hold (vacuum-hold) a substrate in a manufacturing process of a semiconductor device, a liquid crystal display device, or the like. Japanese Patent Laid-Open No. 2022-177165 (Patent literature 1) discloses a technique of, when unloading a substrate in a state in which a vacuum is applied to the substrate and the substrate is clamped by a substrate chuck, supplying a gas to a space between the substrate and the substrate chuck, thereby reducing the wear of the substrate chuck. Patent literature 1 also discloses a technique of stopping the vacuum applied to the substrate from a region outside the substrate in the state in which the substrate is clamped by the substrate chuck.

However, in the conventional technique, if the supply amount of gas supplied to the space between the substrate and the substrate chuck is excessive in the unloading sequence of stopping the holding of the substrate by the substrate chuck, the substrate floats from the substrate chuck and sideslips. In contrast, if the supply amount of gas is too small, the fixation between the substrate and the substrate chuck remains, the substrate is forcibly separated from the substrate chuck, and the substrate chuck wears. When stopping the vacuum applied to the substrate, the time to fill the vacuum-applied space with the gas is necessary, prolonging the unloading time and decreasing the productivity.

### SUMMARY

The present disclosure provides a technique advantageous for stopping holding of a substrate by a chuck.

The present invention in its first aspect provides a holding apparatus as specified in claims 1 to 17.

The present invention in its second aspect provides a substrate processing apparatus as specified in claims 18 and 19.

The present invention in its third aspect provides an article manufacturing method as specified in claim 20.

Further aspects of the present disclosure will become apparent from the following description of exemplary embodiments with reference to the attached drawings.

### BRIEF DESCRIPTION OF THE DRAWINGS

Fig. 1 is a view for describing an exposure apparatus according to an aspect of the present disclosure.
Fig. 2 is a schematic view showing the configuration of a substrate stage according to the first embodiment.
Fig. 3 is a view showing the substrate stage when viewed from the +Z direction.
Figs. 4A to 4C are sectional views of the substrate stage.
Figs. 5A to 5C are sectional views of the substrate stage.
Fig. 6 is a schematic view showing the configuration of a substrate stage according to the second embodiment.
Fig. 7 is a schematic view showing the configuration of a substrate stage according to the third embodiment.
Fig. 8 is a timing chart showing timings to turn on solenoid valves in an operation of transferring a substrate from a substrate chuck to pin members.
Fig. 9 is a timing chart showing timings to turn on solenoid valves in an operation of transferring a substrate from a substrate chuck to pin members.
Figs. 10A and 10B are views showing concrete layout examples of open holes and supply holes.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an embodiment that requires all such features, and multiple such features may be combined as appropriate. Furthermore, in the attached drawings, the same reference numerals are given to the same or similar configurations, and redundant description thereof is omitted.

In the embodiments, a substrate processing apparatus that processes a substrate includes a lithography apparatus, a measurement apparatus, an inspection apparatus, and the like. The lithography apparatus is an apparatus configured to form a pattern on a substrate, and includes, for example, an exposure apparatus, an imprint apparatus, a planarization apparatus, a rendering apparatus, and the like. The exposure apparatus includes an apparatus that projects the pattern of an original (mask or reticle) to a substrate and exposes the substrate. The imprint apparatus includes an apparatus that molds an imprint material on a substrate with a mold and forms the pattern of the imprint material on the substrate. The planarization apparatus includes an apparatus that planarizes a composition on a substrate using a mold having a flat surface. The rendering apparatus includes an apparatus that renders a pattern on a substrate using a charged particle beam (electron beam, ion beam, or the like). The measurement apparatus is an apparatus configured to measure a substrate, and includes, for example, an alignment measurement apparatus used to align an original and a substrate. The inspection apparatus is an apparatus configured to inspect a substrate, and includes, for example, an overlay inspection apparatus that inspects the overlay precision of a pattern formed on a substrate.

### <First Embodiment>

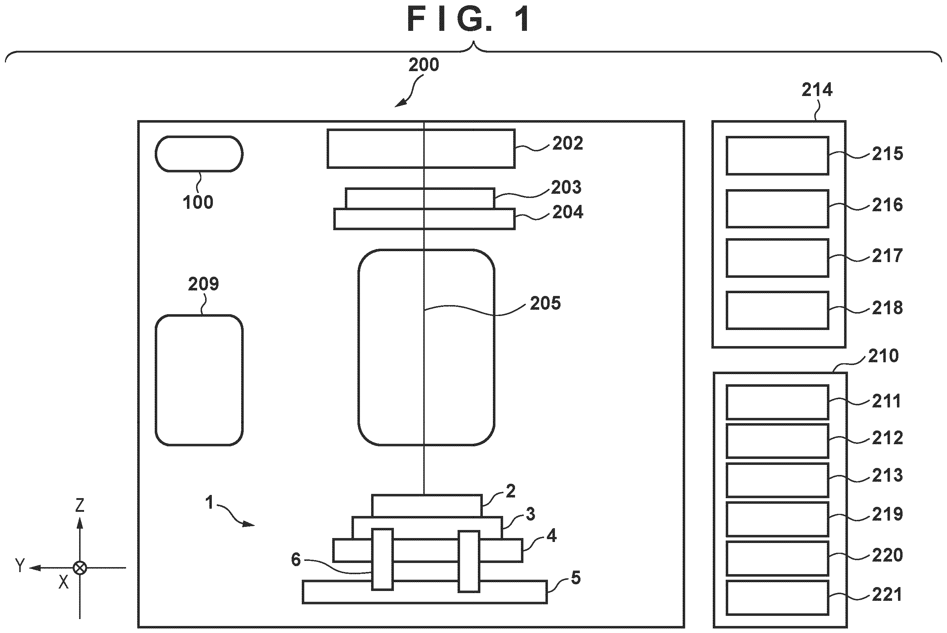

Fig. 1 is a view for describing an exposure apparatus 200 as a substrate processing apparatus according to an aspect of the present disclosure. The exposure apparatus 200 is used for a lithography process that is a manufacturing process of a device such as a semiconductor device or a liquid crystal display device. The exposure apparatus 200 is a lithography apparatus that exposes a substrate using an original to transfer the pattern of the original to the substrate, that is, form the pattern on the substrate.

In this specification and the accompanying drawings, directions are indicated in an XYZ coordinate system in which a direction parallel to a plane on which a substrate is arranged is defined as an X-Y plane. Directions parallel to the X-axis, Y-axis, and Z-axis in the XYZ coordinate system are defined as the X direction, the Y direction, and the Z direction, respectively. A rotation about the X-axis, a rotation about the Y-axis, and a rotation about the Z-axis are defined as θX, θY, and θZ, respectively.

As shown in Fig. 1, the exposure apparatus 200 includes a substrate stage 1, a controller 100, an illumination optical system 202, an original stage 204, a projection optical system 205, an off-axis scope 209, a substrate conveyance system 210, and an original conveyance system 214.

In the exposure apparatus 200, the illumination optical system 202 illuminates an original 203 with light (exposure light) from a light source. The projection optical system 205 has a function of imaging light traveling from an object plane onto an image plane. The projection optical system 205 projects on a substrate 2 the light having passed through (the pattern of) the original 203, and forms the image of the pattern of the original 203 on the substrate.

The original stage 204 holds the original 203 via an original chuck (not shown) configured to chuck (hold) the original 203. The original stage 204 is a stage that linearly moves in the X, Y, and Z directions and is driven to rotate in the θX, θY, and θZ directions. The original stage 204 can independently control driving in each direction. The exposure apparatus 200 includes a laser interferometer (not shown) to measure the position of the original stage 204 at high precision. The position of the original stage 204 is decided from the displacement amount of the original stage 204 that is measured by the laser interferometer.

The original conveyance system 214 includes a hand 215, a pre-alignment stage 216, a conveyance robot 217, and a storage 218. The conveyance robot 217 is constituted by an articulated robot. The conveyance robot 217 includes an original holder that holds the original 203, and can drive the original holder to an arbitrary position in the XYZ space. The storage 218 includes a table on which the original 203 is placed, and stores the original 203 conveyed from outside the apparatus. The original 203 stored in the storage 218 is conveyed to the pre-alignment stage 216 by the conveyance robot 217.

In the pre-alignment stage 216, the mark of the original 203 is detected (observed) by a microscope to measure a positional relationship (misalignment of the original 203 with respect to the pre-alignment stage 216) between the original 203 and the pre-alignment stage 216. After the positional relationship between the original 203 and the pre-alignment stage 216 is measured, the hand 215 holds the original 203 on the pre-alignment stage and drives the original 203 along a guide to a position (original supply position) where the original 203 is handed over to the original stage 204. At the original supply position, the hand 215 hands over the original 203 to the original stage 204. The original stage 204, through an original chuck, vacuum-sucks and holds the original 203. Misalignments of the original 203 with respect to the pre-alignment stage 216 in the X, Y, and θZ directions can be corrected by adjusting the position where the original stage 204 receives the original 203.

The substrate conveyance system 210 includes a supply hand 211, a recovery hand 212, a storage 213, a pre-alignment unit 219, a conveyance robot 220, and a temporary table 221. The storage 213 stores the substrate 2. The conveyance robot 220 is constituted by an articulated robot. The conveyance robot 220 includes a substrate holder that holds the substrate 2, and can drive the substrate holder to an arbitrary position in the XYZ space. The conveyance robot 220 picks up the substrate 2 from the storage 213 and places the substrate 2 in the pre-alignment unit 219. In the pre-alignment unit 219, the periphery of the substrate 2 is irradiated with light, and the reflected light is detected by a sensor to measure the position of the outer shape of the substrate 2 with respect to the pre-alignment unit 219.

The supply hand 211 is a mechanism configured to transfer the substrate 2 from the pre-alignment unit 219 to the substrate stage 1 (pin members 6 provided on a coarse driving stage 5). The supply hand 211 can vacuum-suck and hold the substrate 2. The recovery hand 212 is a mechanism configured to transfer the substrate 2 from the substrate stage 1 to the temporary table 221. The recovery hand 212 can vacuum-suck and hold the substrate 2. The temporary table 221 is a table configured to temporarily place the substrate 2 recovered from the substrate stage 1 by the recovery hand 212. The conveyance robot 220 cannot directly receive the substrate 2 from the recovery hand 212, and thus transfers the substrate 2 via the temporary table 221.

The substrate stage 1 includes a fine driving stage 4 and the coarse driving stage 5. The substrate stage 1 vacuum-sucks and holds the substrate 2 via a substrate chuck 3 placed on the fine driving stage 4. The fine driving stage 4 is a stage that linearly moves in the X, Y, and Z directions and is driven to rotate in the θX, θY, and θZ directions. The fine driving stage 4 can independently control driving in each direction. The exposure apparatus 200 includes a laser interferometer (not shown) to measure the position of the fine driving stage 4 at high precision. The position of the fine driving stage 4 is decided from the displacement amount of the fine driving stage 4 that is measured by the laser interferometer.

The pin member 6 is used when receiving the substrate 2 from the supply hand 211 and when transferring the substrate 2 to the recovery hand 212. The pin member 6 can vacuum-suck and hold the substrate 2. In this embodiment, at least three pin members 6 are fixed to the coarse driving stage 5 and provided to stand with respect to a holding surface of the substrate chuck 3 on which the substrate 2 is held. The pin members 6 are fixed to the coarse driving stage 5 and thus driven together with the coarse driving stage 5. Note that at least three pin members 6 are provided in this embodiment, but the number of pin members 6 is not limited as long as they can satisfactorily and stably hold the substrate 2 in accordance with the size, material, and mass of the substrate 2.

The coarse driving stage 5 is a stage that linearly moves in the X and Y directions and is driven to rotate in the θZ direction. The coarse driving stage 5 is controlled to follow the position of the fine driving stage 4 via an actuator such as a linear motor based on a distance between the coarse driving stage 5 and the fine driving stage 4 that is measured by, for example, a capacitance sensor.

In an outer space (outer space of the substrate chuck 3) as a space around the substrate stage 1, a temperature-controlled gas is supplied from a gas supply port (not shown) provided in the exposure apparatus 200, and the ambient temperature, humidity, and the like of the substrate stage 1 are maintained at predetermined values. Hereinafter, the outer space of the substrate stage 1 in which the ambient temperature, humidity, and the like of the substrate stage 1 are maintained at predetermined values will be sometimes called a stage space.

The off-axis scope 209 measures the position of the substrate 2 by detecting a mark (alignment mark) provided on the substrate 2 held by the substrate stage 1.

The controller 100 is constituted by an information processing apparatus (computer) including a CPU, a memory, and the like. The controller 100 comprehensively controls the respective units of the exposure apparatus 200 to operate the exposure apparatus 200 in accordance with programs stored in a storage unit. The controller 100 controls, for example, a sequence (exposure sequence) regarding exposure processing of exposing the substrate 2, a sequence (supply sequence) of supplying the substrate 2 to the substrate stage 1, a sequence (recovery sequence) of recovering the substrate 2 from the substrate stage 1, and the like.

This embodiment provides a new technique in regard to the recovery sequence of the substrate 2. The recovery sequence of the substrate 2 includes an operation of transferring the substrate 2 held by the substrate stage 1 from the substrate chuck 3 to the pin members 6 after exposing the substrate 2. In the recovery sequence, specifically, an unloading sequence of stopping the holding of the substrate 2 by the substrate chuck 3, a gas is preferably supplied to a space between the substrate 2 and the substrate chuck 3. However, if the supply amount of gas supplied to the space between the substrate 2 and the substrate chuck 3 is excessive, the substrate 2 floats from the substrate chuck 3 and sideslips. To the contrary, if the supply amount of gas supplied to the space between the substrate 2 and the substrate chuck 3 is too small, the fixation between the substrate 2 and the substrate chuck 3 remains, the substrate 2 is forcibly separated from the substrate chuck 3, and the substrate chuck 3 wears. When stopping the vacuum applied to the substrate 2, the time to fill the vacuum-applied space with the gas is necessary, prolonging the unloading time and decreasing the productivity. To solve this, the embodiment provides a new technique capable of reducing the wear of the substrate chuck 3 while suppressing the sideslip of the substrate 2 in the recovery sequence (unloading sequence).

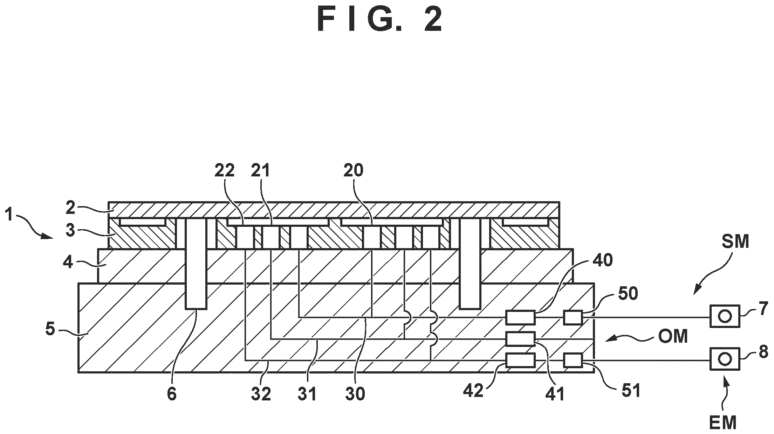

First, a method of vacuum-sucking and holding the substrate 2 by the substrate chuck 3, and a method of supplying a gas to the space between the substrate 2 and the substrate chuck 3 will be explained. Note that the space between the substrate 2 and the substrate chuck 3 will be sometimes called the first space hereinafter. As shown in Fig. 2, the substrate stage 1 includes an exhaust mechanism EM used when holding the substrate 2 by the substrate chuck 3, and a supply mechanism SM and an opening mechanism OM used when stopping the holding of the substrate 2 by the substrate chuck 3. Fig. 2 is a schematic view showing an example of the configuration of the substrate stage 1.

The exhaust mechanism EM is a mechanism configured to exhaust a gas from the first space serving as the space between the substrate 2 and the substrate chuck 3. The exhaust mechanism EM includes a flow path (pipe) 32 (third flow path), a solenoid valve 42 (third valve), and a regulator 51. The supply mechanism SM is a mechanism configured to supply a gas to the first space, and includes a flow path (pipe) 30 (first flow path), a solenoid valve 40 (first valve), and a regulator 50. The opening mechanism OM is a mechanism configured to make the first space and the stage space communicate with each other, and includes a flow path (pipe) 31 (second flow path) and a solenoid valve 41 (second valve).

The substrate stage 1 vacuum-sucks and holds the substrate 2 by the substrate chuck 3 by exhausting the gas from the first space serving as the space between the substrate 2 and the substrate chuck 3 and reducing the pressure by the exhaust mechanism EM. The flow paths 30, 31, and 32 are connected to the substrate chuck 3. The substrate chuck 3 is vacuum-sucked and held on the fine driving stage 4. The fine driving stage 4 is placed on the coarse driving stage 5. In this embodiment, the solenoid valves 40, 41, and 42 and the regulators 50 and 51 are assembled in the coarse driving stage 5.

The flow path 31 connects, via the solenoid valve 41 provided on the flow path 31, the stage space and the first space serving as the space between the substrate 2 and the substrate chuck 3. The flow path 30 connects, via the solenoid valve 40 provided on the flow path 30, the first space and a positive-pressure tank 7 serving as a positive-pressure source (gas supply source) that generates a positive pressure. The positive-pressure tank 7 is provided outside the coarse driving stage 5 and constituted as, for example, a plant facility. The solenoid valve 40 is interposed between the positive-pressure tank 7 and the substrate chuck 3. The flow path 32 connects, via the solenoid valve 42 provided on the flow path 32, the first space serving as the space between the substrate 2 and the substrate chuck 3, and a vacuum pump 8 that generates a negative pressure.

The regulator 51 is interposed between the vacuum pump 8 and the substrate chuck 3, specifically, between the vacuum pump 8 and the solenoid valve 42, and can regulate the pressure of the first space to a desired vacuum pressure. To supply the pressure regulated by the regulator 51 to the substrate chuck 3, the solenoid valve 42 is arranged on the side of the substrate chuck 3 with respect to the regulator 51. Under the control of the controller 100, the solenoid valve 42 is turned on (that is, the solenoid valve 42 is opened) to regulate the pressure of the first space by the vacuum pump 8. Also, under the control of the controller 100, the solenoid valve 42 is turned off (that is, the solenoid valve 42 is closed) to stop the regulation of the pressure of the first space by the vacuum pump 8.

The regulator 50 is interposed between the positive-pressure tank 7 and the substrate chuck 3, specifically, between the positive-pressure tank 7 and the solenoid valve 40, and can regulate the pressure of the gas supplied from the positive-pressure tank 7 to a desired pressure. Regulating the pressure of the gas supplied from the positive-pressure tank 7 also means regulating the flow rate of the gas supplied from the positive-pressure tank 7. To supply the pressure regulated by the regulator 50 to the substrate chuck 3, the solenoid valve 40 is arranged on the side of the substrate chuck 3 with respect to the regulator 50. Under the control of the controller 100, the solenoid valve 40 is turned on (that is, the solenoid valve 40 is opened) to regulate the pressure of the first space by the positive-pressure tank 7. Also, under the control of the controller 100, the solenoid valve 40 is turned off (that is, the solenoid valve 40 is closed) to stop the regulation of the pressure of the first space by the positive-pressure tank 7.

The solenoid valves 40, 41, and 42 may be replaced with servo valves capable of freely setting the opening/closing degree, proportional solenoid valves controllable in proportion to the current, or the like. Although no regulator is provided on the flow path 31 in this embodiment, a regulator may be interposed between the solenoid valve 41 and the stage space to regulate the flow rate of a gas flowing through the flow path 31.

When holding the substrate 2 by the substrate chuck 3, the solenoid valve 42 is turned on to depressurize the first space by the vacuum pump 8 and vacuum-suck the substrate 2 by the substrate chuck 3.

When stopping the holding of the substrate 2 by the substrate chuck 3, the solenoid valve 42 is turned off and the solenoid valves 40 and 41 are turned on to supply the gas from the stage space and the positive-pressure tank 7 to the first space. In other words, when stopping the holding of the substrate 2 by the substrate chuck 3, the supply mechanism SM and the opening mechanism OM are connected so that the gas is supplied from the positive-pressure tank 7 to the first space and the first space and the stage space communicate with each other. According to this embodiment, the space between the substrate 2 and the substrate chuck 3 can be quickly pressurized to stop a vacuum applied to the substrate 2 in a short time. Therefore, prolonging of the unloading time can be avoided, and a decrease in productivity can be suppressed.

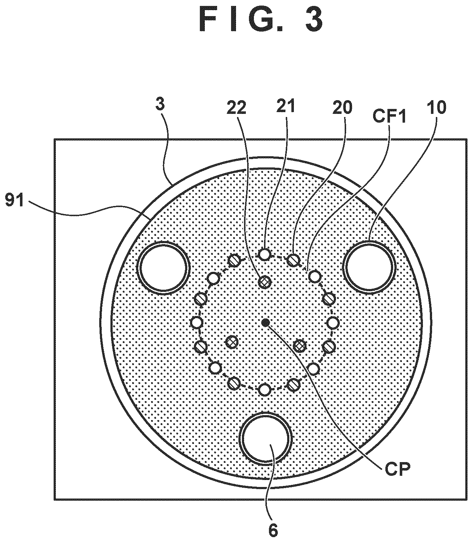

Fig. 3 is a view showing the substrate stage 1 when viewed from the +Z direction. In this embodiment, an annular sealing portion 91 is provided on the substrate chuck 3 along the periphery of the substrate chuck 3, but the sealing portion 91 provided on the substrate chuck 3 is not always necessary. The number and layout of sealing portions 91 provided on the substrate chuck 3 are not limited.

A plurality of projections (not shown) called chuck pins are provided on the substrate chuck 3, and the chuck pins regulate a holding surface on which the substrate 2 is held. On the substrate chuck 3, a supply hole 20 (first hole) continuous with the flow path 30 is provided at the first position, and an open hole 21 (second hole) continuous with the flow path 31 is provided at the second position different from the first position. Also, on the substrate chuck 3, an exhaust hole 22 (third hole) continuous with the flow path 32 is provided at the third position different from the first and second positions.

In this embodiment, eight supply holes 20 and eight open holes 21 are provided alternately on the same circle (concentrically) on which distances from the center of the substrate chuck 3 are equal, and at equal intervals on the same circle. However, the present disclosure is not limited to this. Also, three exhaust holes 22 are provided on the same circle (concentrically) on which distances from the center of the substrate chuck 3 are equal. However, the present disclosure is not limited to this.

As shown in Fig. 3, through holes 10 are provided in the substrate chuck 3 and the fine driving stage 4 so that the pin members 6 pass through the through holes 10. The fine driving stage 4 can be driven in the Z direction without interfering with the pin members 6.

The operation of vacuum-sucking and holding the substrate 2 by the substrate chuck 3 is performed by exhausting, by the exhaust mechanism EM via the exhaust holes 22, the gas in the first space serving as the space between the substrate 2 and the substrate chuck 3. In this manner, the gaps between the substrate 2 and the small chuck pins are evacuated via the exhaust holes 22, and the substrate chuck 3 can vacuum-suck and hold the substrate 2 by a uniform force. In this embodiment, the presence of the sealing portion 91 between the substrate 2 and the substrate chuck 3 can prevent the inflow of the gas (air) from the stage space and enable vacuum-sucking the substrate 2.

The operation of stopping the holding of the substrate 2 by the substrate chuck 3 is performed by supplying, by the supply mechanism SM via the supply holes 20, the gas from the positive-pressure tank 7 to the first space, and making the first space and the stage space communicate with each other by the opening mechanism OM via the open holes 21. Note that, as described above, if the supply amount of gas supplied from the positive-pressure tank 7 to the first space is excessive, the substrate 2 sideslips. If the supply amount of gas supplied from the positive-pressure tank 7 to the first space is too small, the substrate chuck 3 wears.

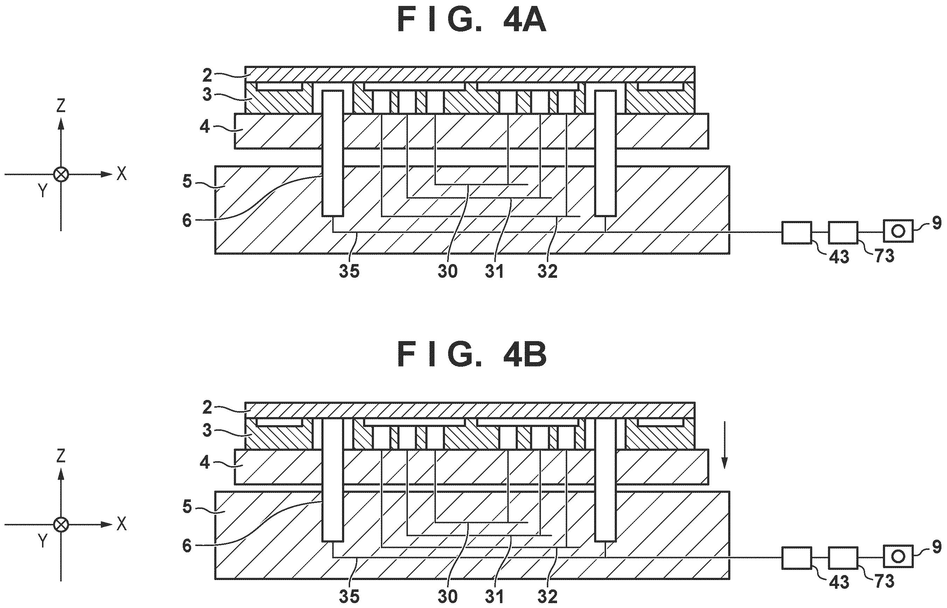

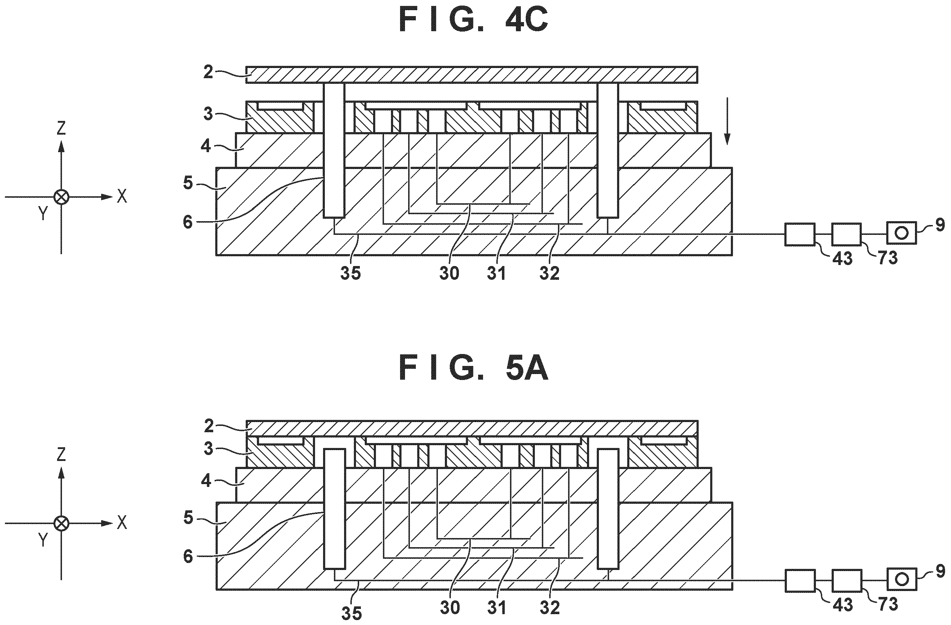

Next, a method of transferring the substrate 2 from the substrate chuck 3 to the pin members 6 will be explained with reference to Figs. 4A, 4B, and 4C. Figs. 4A to 4C are sectional views of the substrate stage 1.

The fine driving stage 4 is driven in the Z direction along the pin members 6. Note that the fine driving stage 4 can be driven while tilted in the Z direction in accordance with the positions of the three pin members 6 in the Z direction. As described above, the pin members 6 are fixed to the coarse driving stage 5 drivable in the X and Y directions. The position of the pin member 6 is measured by a measurement device including, for example, an interferometer, a capacitance sensor, an encoder, and the like.

The pin members 6 are connected to a vacuum pump 9 via a flow path 35. A regulator 73 and a solenoid valve 43 are interposed between the vacuum pump 9 and the pin members 6. To supply a pressure regulated by the regulator 73 to the pin members 6, the solenoid valve 43 is arranged on the side of the pin members 6 with respect to the regulator 51. Under the control of the controller 100, the solenoid valve 43 is turned on (that is, the solenoid valve 43 is opened) to regulate the pressure of the space between the substrate 2 and the substrate chuck 3 by the vacuum pump 9 via the pin members 6. Also, under the control of the controller 100, the solenoid valve 43 is turned off (that is, the solenoid valve 43 is closed) to stop the regulation of the pressure of the space between the substrate 2 and the substrate chuck 3 by the vacuum pump 9 via the pin members 6. In this embodiment, the solenoid valve 43 and the regulator 73 are provided outside the coarse driving stage 5, that is, in the stage space, but may be assembled in the coarse driving stage 5. The vacuum pump 9 is constituted as, for example, a plant facility.

Referring to Fig. 4A, the fine driving stage 4 is position in the +Z direction, and the substrate chuck 3 vacuum-sucks the substrate 2. In Fig. 4B, as indicated by an arrow, the fine driving stage 4 is driven in the -Z direction to bring the pin members 6 and the substrate 2 into contact with each other. At this time, the fine driving stage 4 may stop the driving. After the pin members 6 and the substrate 2 contact each other, the holding of the substrate 2 by the substrate chuck 3 is stopped. In addition, the solenoid valve 43 is turned on to vacuum-suck and hold the substrate 2 by the pin members 6. In the state in which the pin members 6 hold the substrate 2, the fine driving stage 4 is further driven in the -Z direction to transfer the substrate 2 from the substrate chuck 3 to the pin members 6, as shown in Fig. 4C.

Here, the method of driving the fine driving stage 4 to transfer the substrate 2 from the substrate chuck 3 to the pin members 6 has been explained. However, the present disclosure is not limited to this, and it is only necessary to change the relative positions of the substrate chuck 3 and pin members 6 in the Z direction. For example, the whole pin members 6 or their distal ends may be driven in the Z direction to transfer the substrate 2 from the substrate chuck 3 to the pin members 6. Changing the relative positions of the substrate chuck 3 and pin members 6 is synonymous with relatively driving the substrate chuck 3 and the pin members 6.

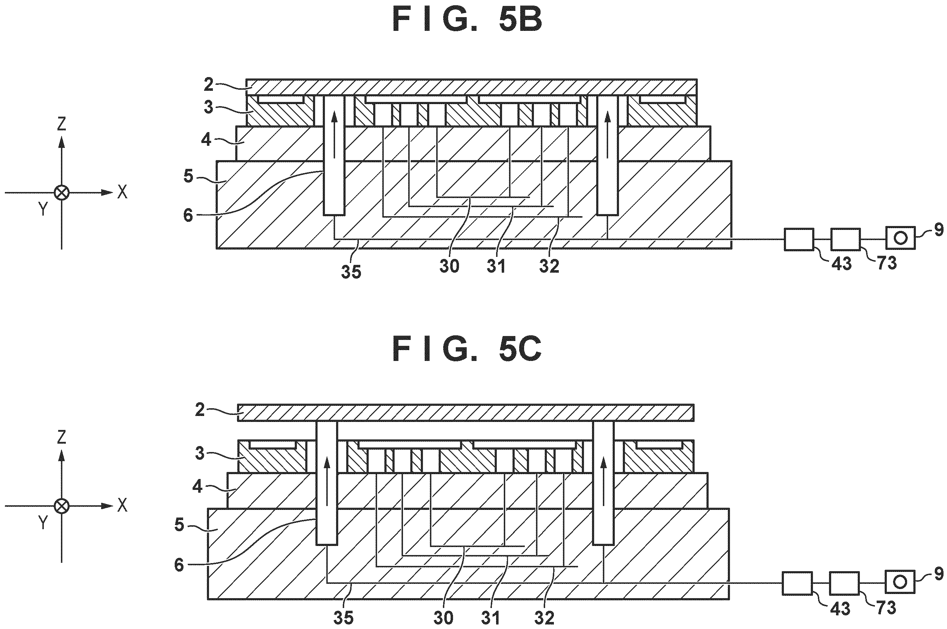

A method of transferring the substrate 2 from the substrate chuck 3 to the pin members 6 by driving the whole pin members 6 in the Z direction will be explained with reference to Figs. 5A, 5B, and 5C. Figs. 5A to 5C are sectional views of the substrate stage 1. A driving unit that drives the pin members 6 may be incorporated in the pin members 6, or provided outside the pin members 6 and connected to the pin members 6. Note that, as described above, the distal ends of the pin members 6 may be driven (extended) in the Z direction to transfer the substrate 2 from the substrate chuck 3 to the pin members 6, instead of driving the whole pin members 6.

Referring to Fig. 5A, the pin members 6 are positioned in the -Z direction and do not contact the substrate 2. In this state, the substrate chuck 3 holds the substrate 2. In Fig. 5B, as indicated by an arrow, the pin members 6 are driven in the +Z direction and comes into contact with the substrate 2. After the pin members 6 and the substrate 2 contact each other, the driving of the pin members 6 is stopped, and the holding of the substrate 2 by the substrate chuck 3 is stopped. Then, the solenoid valve 43 is turned on to vacuum-suck the substrate 2 by the pin members 6. In the state in which the pin members 6 hold the substrate 2, the pin members 6 are further driven in the +Z direction to transfer the substrate 2 from the substrate chuck 3 to the pin members 6, as shown in Fig. 5C.

The reason that the space between the substrate 2 and the substrate chuck 3 is quickly pressurized to stop a vacuum applied to the substrate 2 in a short time while suppressing the sideslip of the substrate 2 and the wear of the substrate chuck 3 in this embodiment will be explained in detail.

According to this embodiment, in the substrate stage 1 functioning as a substrate holding apparatus, the flow path 31 is assembled in the coarse driving stage 5 and communicates with a space continuous with a side opposite to the back surface of the substrate 2 (surface opposite to a surface held by the substrate chuck 3), that is, the stage space. When supplying a gas via the supply holes 20, the solenoid valve 41 is turned on to make the stage space and the first space serving as the space between the substrate 2 and the substrate chuck 3 communicate with each other via the open holes 21 and the flow path 31. When stopping the holding of the substrate 2 by the substrate chuck 3, not only the gas from the positive-pressure tank 7, but also the gas from the stage space are supplied (flow) into the first space, so the vacuum applied to the substrate 2 can be stopped in a short time. According to this embodiment, prolonging of the unloading time can be avoided, and a decrease in productivity can be suppressed.

In this embodiment, if the pressure of the first space serving as the space between the substrate 2 and the substrate chuck 3 becomes higher than that of the stage space, the flow of the gas from the first space toward the stage space is formed via the open holes 21 (and the flow path 31). Since an excessive amount of gas supplied to the first space can be let out to the stage space, the sideslip of the substrate 2 and the wear of the substrate chuck 3 can be suppressed.

In this embodiment, the solenoid valve 41 provided on the flow path 31 communicating with the stage space is assembled in the coarse driving stage 5. This can shorten the length of the flow path 31 and improve the responsibility of the flow of the gas supplied from the stage space to the first space serving as the space between the substrate 2 and the substrate chuck 3, contributing to shortening the time taken to stop the holding of the substrate 2 by the substrate chuck 3.

When the flow of the gas toward the stage space from the first space serving as the space between the substrate 2 and the substrate chuck 3 is formed via the open holes 21, the first space and the stage space may communicate with each other via the gap between the substrate 2 and the substrate chuck 3. Since an excessive amount of gas supplied to the first space can be more efficiently let out to the stage space, the wear of the substrate chuck 3 can be suppressed more reliably. Note that there is the flow of the gas from the first space to the stage space via the open holes 21, so not all the gas supplied from the positive-pressure tank 7 to the first space via the supply holes 20 escapes (flows) from the gap between the substrate 2 and the substrate chuck 3. Thus, the sideslip of the substrate 2 is still suppressed.

One positive-pressure tank 7 is provided in this embodiment, but a plurality of positive-pressure tanks may be provided for the flow path 30. In this case, the supply amount of gas supplied to the first space serving as the space between the substrate 2 and the substrate chuck 3 can be increased, and a sufficient amount of gas can be supplied even for a substrate that greatly warps and increases the first space. Similarly, one vacuum pump 8 is provided in this embodiment, but a plurality of vacuum pumps may be provided for the flow path 32. In this case, the exhaust amount of gas exhausted from the first space can be increased, and a sufficient amount of gas can be exhausted even for a substrate that greatly warps and increases the first space.

In this embodiment, the timing to turn on the solenoid valve 40 and the timing to turn on the solenoid valve 41 are not particularly limited. For example, in a case where the gas needs to be supplied in a shorter time to the first space serving as the space between the substrate 2 and the substrate chuck 3, it may be controlled to turn on the solenoid valve 40 and then turn on the solenoid valve 41. In a case where the sideslip of the substrate 2 needs to be more reliably suppressed, it may be controlled to turn on the solenoid valve 41 and then turn on the solenoid valve 40. In this way, the timings to turn on the solenoid valves 40 and 41, respectively, that is, the timing to supply the gas via the supply holes 20 and the timing to make the first space and the stage space communicate with each other via the open holes 21 can be controlled (set) in accordance with the purpose.

### <Second Embodiment>

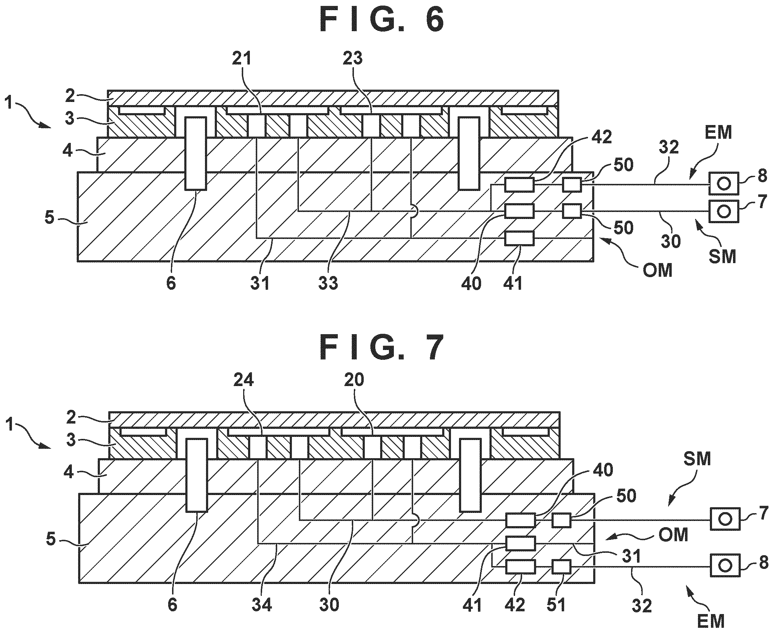

A substrate stage 1 according to the second embodiment will be described with reference to Fig. 6. Fig. 6 is a schematic view showing an example of the configuration of the substrate stage 1. In this embodiment, as shown in Fig. 6, the substrate stage 1 has a configuration in which a flow path 30 for supplying a gas from a positive-pressure tank 7 to the first space serving as a space between a substrate 2 and a substrate chuck 3, and a flow path 32 for exhausting the gas from the first space are integrated.

In Fig. 6, a flow path 33 functions as a flow path for supplying the gas from the positive-pressure tank 7 to the first space, and a flow path for exhausting the gas from the first space. The flow paths 30 and 32 merge between the substrate chuck 3 and solenoid valves 40 and 42. In accordance with ON/OFF switching of the solenoid valves 40 and 42, supply of the gas to the first space and exhaust of the gas from the first space are performed via supply/exhaust holes 23.

When holding the substrate 2 by the substrate chuck 3, the solenoid valve 42 is turned on, and the solenoid valves 40 and 41 are turned off to depressurize the first space by a vacuum pump 8 and vacuum-suck the substrate 2 by the substrate chuck 3. In this embodiment, an exhaust mechanism EM exhausts the gas from the first space via (the supply/exhaust holes 23 functioning as even) supply holes 20 provided in the substrate chuck at the thought of the first embodiment.

When stopping the holding of the substrate 2 by the substrate chuck 3, the solenoid valve 42 is turned off, and the solenoid valves 40 and 41 are turned on to supply the gas from the stage space and a positive-pressure tank 7 to the first space. In other words, when stopping the holding of the substrate 2 by the substrate chuck 3, a supply mechanism SM and an opening mechanism OM are controlled to supply the gas from the positive-pressure tank 7 to the first space and make the first space and the stage space communicate with each other. According to this embodiment, the space between the substrate 2 and the substrate chuck 3 can be quickly pressurized to stop a vacuum applied to the substrate 2 in a short time. Thus, prolonging of the unloading time can be avoided, and a decrease in productivity can be suppressed.

In this embodiment, if the pressure of the first space serving as the space between the substrate 2 and the substrate chuck 3 becomes higher than that of the stage space, the flow of the gas from the first space toward the stage space is formed via open holes 21 (and a flow path 31). Since an excessive amount of gas supplied to the first space can be let out to the stage space, the sideslip of the substrate 2 and the wear of the substrate chuck 3 can be suppressed. At this time, the first space and the stage space may communicate with each other via the gap between the substrate 2 and the substrate chuck 3. Since an excessive amount of gas supplied to the first space can be let out more efficiently to the stage space, the wear of the substrate chuck 3 can be suppressed more reliably.

In this embodiment, the apparatus configuration can be simplified by integrating the flow path 30 for supplying a gas from the positive-pressure tank 7 to the first space serving as the space between the substrate 2 and the substrate chuck 3, and the flow path 32 for exhausting the gas from the first space. Even if the flow paths 30 and 32 are integrated, the gas can be supplied from the positive-pressure tank 7 to the first space when stopping the holding of the substrate 2 by the substrate chuck 3, and the first space can be opened (air release) to the stage space via the open holes 21. Hence, the gas is supplied (flows) from the stage space to the first space, and the time taken to stop the holding of the substrate 2 by the substrate chuck 3 can be shortened.

Note that the number of positive-pressure tanks 7, that of vacuum pumps 8, the timings to turn on the solenoid valves 40 and 41, and the like are similar to those in the first embodiment.

### <Third Embodiment>

A substrate stage 1 according to the third embodiment will be described with reference to Fig. 7. Fig. 7 is a schematic view showing an example of the configuration of the substrate stage 1. In this embodiment, as shown in Fig. 7, the substrate stage 1 has a configuration in which a flow path 31 for making the stage space and the first space serving as a space between a substrate 2 and a substrate chuck 3 communicate with each other (the first space is open to the atmosphere), and a flow path 32 for exhausting a gas from the first space are integrated.

In Fig. 7, a flow path 34 functions as a flow path for making the stage space and the first space serving as the space between the substrate 2 and the substrate chuck 3 communicate with each other, and a flow path for exhausting the gas from the first space. The flow paths 31 and 32 merge between the substrate chuck 3 and solenoid valves 41 and 42. In accordance with ON/OFF switching of the solenoid valves 41 and 42, communication between the first space and the stage space and exhaust of the gas from the first space are performed via open/exhaust holes 24.

When holding the substrate 2 by the substrate chuck 3, the solenoid valve 42 is turned on, and the solenoid valves 40 and 41 are turned off to depressurize the first space by a vacuum pump 8 and vacuum-suck the substrate 2 by the substrate chuck 3. In this embodiment, an exhaust mechanism EM exhausts the gas from the first space via (the open/exhaust holes 24 functioning as even) open holes 21 provided in the substrate chuck in the case of the first embodiment.

When stopping the holding of the substrate 2 by the substrate chuck 3, the solenoid valve 42 is turned off, and the solenoid valves 40 and 41 are turned on to supply the gas from the stage space and a positive-pressure tank 7 to the first space. In other words, when stopping the holding of the substrate 2 by the substrate chuck 3, a supply mechanism SM and an opening mechanism OM are controlled to supply the gas from the positive-pressure tank 7 to the first space and make the first space and the stage space communicate with each other. According to this embodiment, the space between the substrate 2 and the substrate chuck 3 can be quickly pressurized to stop a vacuum applied to the substrate 2 in a short time. Hence, prolonging of the unloading time can be avoided, and a decrease in productivity can be suppressed.

In this embodiment, if the pressure of the first space serving as the space between the substrate 2 and the substrate chuck 3 becomes higher than that of the stage space, the flow of the gas from the first space toward the stage space is formed via the open/exhaust holes 24 (and the flow path 34). Since an excessive amount of gas supplied to the first space can be let out to the stage space, the sideslip of the substrate 2 and the wear of the substrate chuck 3 can be suppressed. At this time, the first space and the stage space may communicate with each other via the gap between the substrate 2 and the substrate chuck 3. Since an excessive amount of gas supplied to the first space can be let out more efficiently to the stage space, the wear of the substrate chuck 3 can be suppressed more reliably.

In this embodiment, the apparatus configuration can be simplified by integrating the flow path 31 for making the stage space and the first space serving as the space between the substrate 2 and the substrate chuck 3 communicate with each other, and the flow path 32 for exhausting the gas from the first space. Even if the flow paths 31 and 32 are integrated, the gas can be supplied from the positive-pressure tank 7 to the first space when stopping the holding of the substrate 2 by the substrate chuck 3, and the first space can be opened (air release) to the stage space via the open/exhaust holes 24. The gas is therefore supplied (flows) from the stage space to the first space, and the time taken to stop the holding of the substrate 2 by the substrate chuck 3 can be shortened.

Note that the number of positive-pressure tanks 7, that of vacuum pumps 8, the timings to turn on the solenoid valves 40 and 41, and the like are similar to those in the first embodiment.

### <Fourth Embodiment>

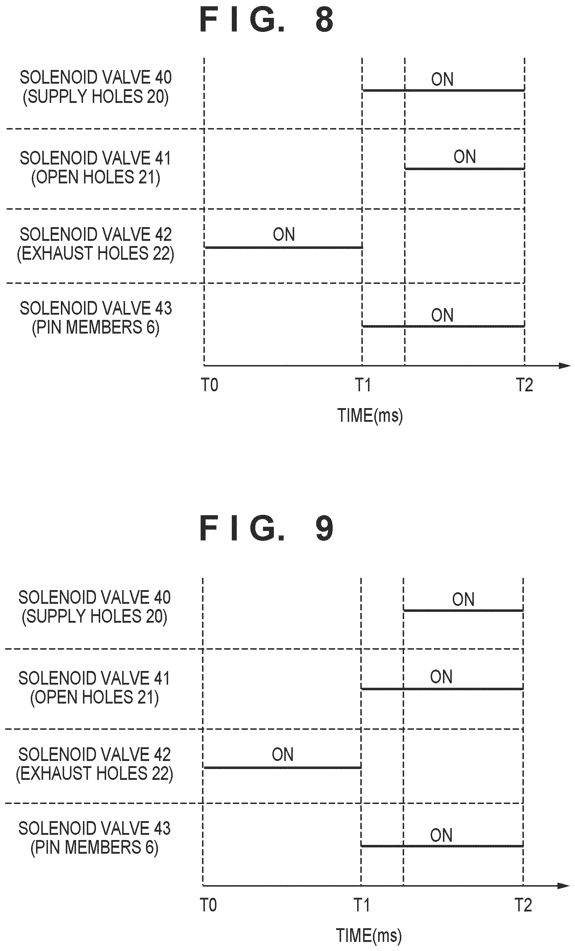

In the fourth embodiment, timings to turn on respective solenoid valves 40, 41, 42, and 43 will be explained by exemplifying a substrate stage 1 shown in Fig. 2. Fig. 8 is a timing chart showing timings to turn on the respective solenoid valves 40, 41, 42, and 43 in an operation of transferring a substrate 2 from a substrate chuck 3 to pin members 6. In Fig. 8, the abscissa represents the time.

Referring to Fig. 8, T0 represents time when the operation of transferring the substrate 2 from the substrate chuck 3 to the pin members 6 starts. At time T0, as shown in Fig. 4A, a fine driving stage 4 is positioned on a side in the +Z direction, and the substrate chuck 3 vacuum-sucks and holds the substrate 2. T1 represents time when the substrate 2 and the pin members 6 contact each other, as shown in Fig. 4B. T2 represents time when the operation of transferring the substrate 2 from the substrate chuck 3 to the pin members 6 is completed, as shown in Fig. 4C. For easy understanding, Fig. 8 shows even a member connected to each solenoid valve via a flow path. Note that Fig. 8 shows only the time during which the solenoid valves are ON from T0 to T2, and does not show the time during which the solenoid valves are OFF.

As shown in Fig. 8, at time T0, the solenoid valve 42 is turned on, and the substrate 2 is vacuum-sucked and held by the substrate chuck 3. The fine driving stage 4 is driven in the -Z direction, and at time T1, the substrate 2 and the pin members 6 contact each other. At time T1, the solenoid valve 42 is turned off, the solenoid valve 43 is turned on, and the substrate 2 is vacuum-sucked and held by the pin members 6. Simultaneously when the substrate 2 is held by the pin members 6, the solenoid valve 40 is turned on, and a gas is supplied from a positive-pressure tank 7 via supply holes 20 to the first space serving as a space between the substrate 2 and the substrate chuck 3. As a result, the first space changes from a pressure-reduced state (depressurized state) toward an atmospheric-pressure state.

After the solenoid valve 40 is turned on, the solenoid valve 41 is turned on to make the first space and the stage space communicate with each other via open holes 21 and supply the gas from the stage space to the first space (open the first space to the atmosphere). This can shorten the time during which the first space changes from the depressurized state toward the atmospheric-pressure state, and suppress a decrease in productivity. Note that when the pressure of the first space becomes the atmospheric pressure and becomes higher than that of the stage space, the gas flows from the first space to the stage space via the open holes 21. This can suppress the sideslip of the substrate 2. Further, a portion at which the first space and the stage space communicate with each other from a gap between the substrate 2 and the substrate chuck 3 without the intervention of the open holes 21 is formed at the end of the substrate 2. This can suppress the wear of the substrate chuck 3 generated when the substrate 2 is separated from the substrate chuck 3.

In this manner, in a case where the substrate 2 has an upward convex shape, it is effective to control a supply mechanism SM and an opening mechanism OM so that the timing to turn on (open) the solenoid valve 40 becomes earlier than the timing to turn on (open) the solenoid valve 41. In the case where the substrate 2 has an upward convex shape, a large amount of gas is necessary until the first space changes from the depressurized state toward the atmospheric-pressure state when the gas is supplied via the supply holes 20 to the first space serving as the space between the substrate 2 and the substrate chuck 3. The supply mechanism SM is controlled to increase the supply amount of gas supplied from the positive-pressure tank 7 to the first space via the supply holes 20. However, if a large amount of gas is supplied to the first space at a time, the substrate 2 may sideslip. In this embodiment, the sideslip of the substrate 2 is suppressed by turning on the solenoid valve 40, and then turning on the solenoid valve 41 to supply the gas to the first space stepwise. By supplying the gas to the first space, the pressure of the first space changes to the atmospheric-pressure state. If the pressure of the first space becomes higher than that of the stage space, the gas still flows from the first space to the stage space via the open holes 21 or from the gap between the substrate 2 and the substrate chuck 3. Thus, the wear of the substrate chuck 3 generated when the substrate 2 is separated from the substrate chuck 3 can be suppressed.

Note that the timing to turn on the solenoid valve 43 and the timing to turn on the solenoid valve 40 coincide with each other in this embodiment, but the present disclosure is not limited to this. A predetermined time is required until the pressure of the first space becomes the atmospheric pressure after supplying the gas to the first space via the supply holes 20. Considering the time, the timing to turn on the solenoid valve 40 may be set earlier than the timing to turn on the solenoid valve 43. This can further suppress a decrease in productivity. This also applies to the timing to turn on the solenoid valve 41.

### <Fifth Embodiment>

In the fifth embodiment, timings to turn on respective solenoid valves 40, 41, 42, and 43 will be explained by exemplifying a substrate stage 1 shown in Fig. 2. Fig. 9 is a timing chart showing timings to turn on the respective solenoid valves 40, 41, 42, and 43 in an operation of transferring a substrate 2 from a substrate chuck 3 to pin members 6. In Fig. 9, the abscissa represents the time. Note that the fifth embodiment is different from the fourth embodiment (Fig. 8) only in the timing to turn on the solenoid valve 40 and the timing to turn on the solenoid valve 41, as shown in Fig. 9. More specifically, in the fifth embodiment, a supply mechanism SM and an opening mechanism OM are controlled so that the timing to turn on (open) the solenoid valve 40 becomes later than the timing to turn on (open) the solenoid valve 41.

Control of the timings to turn on the respective solenoid valves 40 and 41 in this embodiment is effective in a case where the substrate 2 has a downward convex shape. In the case where the substrate 2 has a downward convex shape, when the first space and the stage space communicate with each other from a gap between the substrate 2 and the substrate chuck 3 at the end of the substrate 2, a large amount of gas flows from the gap to the stage space, and the substrate 2 may sideslip. In this embodiment, the sideslip of the substrate 2 is suppressed by turning on the solenoid valve 41, and then turning on the solenoid valve 40 to reduce the amount of gas flowing to the stage space from the gap between the substrate 2 and the substrate chuck 3.

In the fourth and fifth embodiments, the timing to turn on the solenoid valve 40 and the timing to turn on the solenoid valve 41 are made different in accordance with the shape (upward convex shape or downward convex shape) of the substrate 2. Note that in a case where the substrate 2 has a flat shape, it suffices to control the supply mechanism SM and the opening mechanism OM so that the timing to turn on the solenoid valve 40 and the timing to turn on the solenoid valve 41 coincide with each other. This can suppress the sideslip of the substrate 2 while efficiently shortening the time during which the first space changes from the depressurized state toward the atmospheric-pressure state. Note that the timings to turn on respective solenoid valves 40 and 41 can be controlled (set) in accordance with a result obtained by measuring the shape of the substrate 2 in advance. Such timing information is stored in a storage unit such as the memory of a controller 100.

### <Sixth Embodiment>

In the sixth embodiment, the positional relationship between supply holes 20 and open holes 21 will be explained. The open holes 21 are provided near the supply holes 20. When supplying a gas via the supply holes 20 to the first space serving as a space between a substrate 2 and a substrate chuck 3, the gas may be abruptly supplied to the first space at the timing when a solenoid valve 40 is turned on. In this case, the first space and the stage space may unintentionally communicate with each other from a gap between the substrate 2 and the substrate chuck 3 at the end of the substrate 2, a large amount of gas may flow from the first space into the stage space, and the substrate 2 may sideslip. However, by providing the open holes 21 near the supply holes 20, a conductance when the gas present in the first space flows from the supply holes 20 toward the open holes 21 can be lower than a conductance when the gas flows from the supply holes 20 toward the gap at the end of the substrate 2. This can reduce an unintentional flow of the gas present in the first space from the gap at the end of the substrate 2 to the stage space, and suppress the sideslip of the substrate 2.

In this embodiment, providing the open holes 21 near the supply holes 20 means providing the supply holes 20 and the open holes 21 in the substrate chuck 3 so that the distance between the position of the supply hole 20 and that of the open hole 21 becomes five multiples (inclusive) to 75 multiples (inclusive) of the diameter of the open hole 21. In a case where the distance between the supply hole 20 and the open hole 21 is short, the gas supplied to the first space flows into the closest open holes 21, and it becomes difficult to increase the pressure of the first space. In separating the substrate 2 from the substrate chuck 3, the substrate chuck 3 readily wears. In contrast, in a case where the distance between the supply hole 20 and the open hole 21 is long, the time is taken until the gas supplied to the first space flows into the open holes 21, so the pressure of the first space readily increases. As a result, the gas may flow from the gap at the end of the substrate 2 before the gas supplied to the first space flows to the open holes 21, so the substrate 2 readily sideslips. It is therefore preferable to provide the supply holes 20 and the open holes 21 in the substrate chuck 3 so that the distance between the supply hole 20 and the open hole 21 becomes five multiples (inclusive) to 75 multiples (inclusive) of the diameter of the open hole 21.

Concrete layout examples of the open holes 21 and the supply holes 20 will be explained to provide the open holes 21 near the supply holes 20, that is, set the distance between the supply hole 20 and the open hole 21 to be five multiples (inclusive) to 75 multiples (inclusive) of the diameter of the open hole 21.

For example, as shown in Fig. 3, the supply holes 20 are provided at a plurality of first positions on a circle CF1 (on the first circle) on which a distance from a center CP of the substrate chuck 3 becomes the first distance, and the open holes 21 are provided at a plurality of second positions on the circle CF 1 different from the first positions. On the circle CF1, the supply holes 20 and the open holes 21 are alternately provided. At this time, it is preferable to provide the supply holes 20 and the open holes 21 at equal intervals.

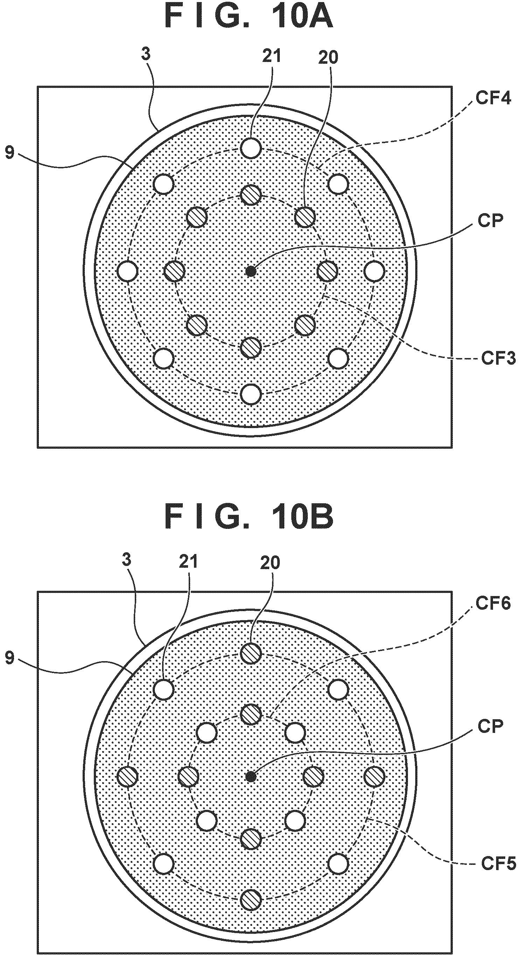

Alternatively, the supply holes 20 and the open holes 21 may be provided on different circles, as shown in Fig. 10A. More specifically, the supply holes 20 are provided at a plurality of first positions on a circle CF3 (on the first circle) on which a distance from the center CP of the substrate chuck 3 becomes the first distance. To the contrary, the open holes 21 are provided at a plurality of second positions on a circle CF4 (on the second circle) on which a distance from the center CP of the substrate chuck 3 becomes the second distance different from the first distance. At this time, it is preferable to provide the supply holes 20 on the circle CF3 at equal intervals and provide the open holes 21 on the circle CF4 at equal intervals. Further, it is preferable to set the first distance to be shorter than the second distance, and provide the open holes 21 outside the supply holes 20 when viewed from the center CP of the substrate chuck 3.

Alternatively, the supply holes 20 and the open holes 21 may be provided concentrically, as shown in Fig. 10B. More specifically, the supply holes 20 are provided at a plurality of first positions on a circle CF5 (on the first circle) on which a distance from the center CP of the substrate chuck 3 becomes the first distance, and at a plurality of first positions on a circle CF6 (on the second circle) on which a distance from the center CP becomes the second distance different from the first distance. In contrast, the open holes 21 are provided at a plurality of second positions different from the first positions on the circle CF5 (on the first circle) on which a distance from the center CP of the substrate chuck 3 becomes the first distance, and at a plurality of second positions different from the first positions on the circle CF6 (on the second circle) on which a distance from the center CP becomes the second distance. On each of the circles CF5 and CF6, the supply holes 20 and the open holes 21 are alternately provided. At this time, it is preferable to provide the supply holes 20 and the open holes 21 at equal intervals. Further, the supply holes 20 are preferably aligned on a first straight line SL1 passing through the center CP of the substrate chuck 3, and provided (that is, on the first straight line), and the open holes 21 are preferably aligned on a second straight line SL2 passing through the center CP that is different from the first straight line SL1, and provided (that is, on the second straight line).

### <Seventh Embodiment>

An article manufacturing method according to an embodiment of the present disclosure is suitable for manufacturing an article, for example, a device (a semiconductor device, magnetic storage medium, liquid crystal element, or the like). This manufacturing method includes a step of forming a pattern on a substrate by using the exposure apparatus 200, a step of processing the substrate on which the pattern has been formed, and a step of manufacturing an article from the processed substrate. This manufacturing method can further includes other known steps (oxidation, deposition, vapor deposition, doping, planarization, etching, resist removal, dicing, bonding, packaging, and the like). The article manufacturing method according to this embodiment is advantageous in at least one of the performance, the quality, the productivity, and the production cost of the article, as compared to a conventional method.)

While the present disclosure has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A holding apparatus that holds a substrate, comprising:
a chuck configured to hold the substrate;
a supply mechanism configured to supply a gas to a first space between the substrate and the chuck via first holes provided at first positions of the chuck;
an opening mechanism configured to make the first space and an outer space communicate with each other via second holes provided at second positions of the chuck that are different from the first positions; and
a controller configured to control the supply mechanism and the opening mechanism so that a period during which holding of the substrate by the chuck is stopped includes a period during which supplying of the gas to the first space and communicating between the first space and the outer space are performed simultaneously.

2. The apparatus according to claim 1, wherein the first hole and the second hole are provided in the chuck to have a distance between the first position and the second position to be not less than five multiples to not more than 75 multiples of a diameter of the second hole.

3. The apparatus according to claim 1, wherein the first holes are provided at a plurality of first positions on a first circle on which a distance from a center of the chuck is a first distance,
the second holes are provided at a plurality of second positions on the first circle that are different from the plurality of first positions, and
the first holes and the second holes are alternately provided on the first circle.

4. The apparatus according to claim 3, wherein the first holes and the second holes are provided on the first circle at equal intervals.

5. The apparatus according to claim 3, wherein the first holes are provided at a plurality of first positions on a second circle on which the distance from the center of the chuck is a second distance different from the first distance,
the second holes are provided at a plurality of second positions on the second circle that are different from the plurality of first positions, and
the first holes and the second holes are alternately provided on the second circle.

6. The apparatus according to claim 5, wherein the first holes and the second holes are provided on the second circle at equal intervals.

7. The apparatus according to claim 5, wherein the first holes are provided on a first straight line passing through the center of the chuck, and
the second holes are provided on a second straight line passing through the center of the chuck that is different from the first straight line.

8. The apparatus according to claim **1,** wherein the first holes are provided at a plurality of first positions on a first circle on which a distance from a center of the chuck is a first distance, and
the second holes are provided at a plurality of second positions on a second circle on which the distance from the center of the chuck is a second distance different from the first distance.

9. The apparatus according to claim 8, wherein the first holes are provided on the first circle at equal intervals, and
the second holes are provided on the second circle at equal intervals.

10. The apparatus according to claim 8, wherein the first distance is shorter than the second distance.

11. The apparatus according to claim 1, further comprising an exhaust mechanism configured to, when holding the substrate by the chuck, exhaust the gas from the first space via third holes provided at third positions of the chuck that are different from the first positions and the second positions.

12. The apparatus according to claim 1, further comprising an exhaust mechanism configured to, when holding the substrate by the chuck, exhaust the gas from the first space via the first holes provided in the chuck.

13. The apparatus according to claim 1, further comprising an exhaust mechanism configured to, when holding the substrate by the chuck, exhaust the gas from the first space via the second holes provided in the chuck.

14. The apparatus according to claim 1, wherein the supply mechanism includes a first flow path configured to connect the first space and a supply source of the gas, and a first valve provided on the first flow path,
the opening mechanism includes a second flow path configured to connect the first space and the outer space, and a second valve provided on the second flow path, and
the controller controls the supply mechanism to open the first valve and supply the gas from the supply source to the first space via the first flow path, and
controls the opening mechanism to open the second valve and make the first space and the outer space communicate with each other.

15. The apparatus according to claim 14, wherein the controller controls the supply mechanism and the opening mechanism to make a timing to open the first valve and a timing to open the second valve coincide with each other.

16. The apparatus according to claim 14, wherein the controller controls the supply mechanism and the opening mechanism to set a timing to open the first valve to be earlier than a timing to open the second valve.

17. The apparatus according to claim 14, wherein the controller controls the supply mechanism and the opening mechanism to set a timing to open the first valve to be later than a timing to open the second valve.

18. A substrate processing apparatus that processes a substrate, comprising:
a holding apparatus configured to hold the substrate, the holding apparatus including the holding apparatus according to claim 1.

19. The apparatus according to claim 18, further comprising:
an illumination optical system configured to illuminate an original; and
a projection optical system configured to project a pattern of the original to the substrate.

20. An article manufacturing method comprising:
forming a pattern on a substrate using the substrate processing apparatus according to claim 18;
processing the substrate on which the pattern is formed in the forming; and
manufacturing an article from the processed substrate.
